# EUROPÄISCHE PATENTSCHRIFT

(11) **EP 2 885 647 B1**
(45) Veröffentlichungstag und Bekanntmachung des Hinweises auf die Patenterteilung: **05.01.2022**
(21) Anmeldenummer: 13748051.3
(22) Anmeldetag: 13.08.2013
(51) Int. Cl.: G01R 33/07, G01R 15/20

(54) **MESSEINRICHTUNG FÜR EINE KONTAKTLOSE STROMMESSUNG**
MEASURING DEVICE FOR A CONTACTLESS CURRENT MEASUREMENT
DISPOSITIF DE MESURE POUR UNE MESURE DE COURANT SANS CONTACT

(30) Priorität: 14.08.2012 DE 202012103071 U
(43) Veröffentlichungstag der Anmeldung: 24.06.2015
(73) Patentinhaber: Rauschert Heinersdorf-Pressig GmbH, 96332 Pressig (DE); Fraunhofer-Gesellschaft zur Förderung der angewandten Forschung e.V., 80686 München (DE)
(72) Erfinder: HACKNER, Michael, 93155 Hemau (DE); TISCHLINGER, Gerhard, 90403 Nürnberg (DE); FIEDLER, Alfred, 96332 Pressig (DE)
(74) Vertreter: Sperschneider, Alexandra
(86) Internationale Anmeldenummer: PCT/EP2013/066868
(87) Internationale Veröffentlichungsnummer: WO 2014/026963

(56) Entgegenhaltungen:
- DE-A1-102007 035 184
- US-A- 3 372 361
- US-A1- 2006 006 976
- US-A1- 2010 237 853
- None

## Beschreibung

Die Erfindung betrifft eine Messeinrichtung für mindestens eine kontaktlose Strommessung an einem stromdurchflossenen elektrischen Leiter mit den im Oberbegriff des Anspruchs 1 angegebenen Merkmalen.

Eine Strommessvorrichtung der gattungsgemäßen Art ist aus der DE 20 2008 012 593 U1 bekannt. Die darin angegebene Strommessvorrichtung weist ein ein- oder mehrteiliges Gehäuse auf, in dem ein Sensor in unmittelbarer Nähe des zu messenden, stromführenden Leiters angeordnet ist. Der durch den magnetfeldempfindlichen Sensor definierte Messbereich des Leiters wird bei geschlossenem Gehäuse durch eine Abschirmkammer aus einer Abschirmung aus einen nicht magnetisierbaren metallischen Werkstoff umschlossen. Als Sensor kommt ein Hallsensor mit Polaritätserkennung zum Einsatz, der in einem nachgeschalteten Verstärkerschaltkreis eingebunden ist. Die elektrische Auswerteinrichtung ist in dem Gehäuse ebenfalls untergebracht. In den Seitenwänden des Gehäuses sind halbschalenförmige Ausnehmungen zur Aufnahme des Leiters eingebracht. Der aufsetzbare Deckel bildet die andere Hälfte der Ausnehmung und beinhaltet einen Teil der Abschirmung. Im Gehäuse ist ferner ein Anschluss untenseitig vorgesehen, um die Messdaten aus einem Speicher auslesen zu können. Der Hallsensor erfasst das in Folge des Stromdurchflusses durch den Leiter entstehende Magnetfeld und gibt damit ein proportionales Signal für die Größe des fließenden Stromes an.

Aus der 20 2007 005 947 U1 ist eine Messeinrichtung für eine kontaktlose Strommessung an einem stromdurchflossenen elektrischen Leiter ebenfalls bekannt, wobei mindestens ein als Strommesssensor vorgesehener Hallsensor mit einer entsprechenden Auswerteeinrichtung in einem Gehäuse angeordnet ist, das zumindest teilweise von einer elektrisch abschirmenden Abdeckung umgeben ist und auf einem stromdurchflossenen elektrischen Leiter mittels einer lösbaren Haltevorrichtung fixierbar ist. An der in dem Gehäuse vorhandenen Leiterplatte ist ebenfalls ein elektrischer Steckverbinder befestigt, der durch einen Durchbruch in einer Seitenwand zugänglich ist. Die Messeinrichtung wird auf einen Stromleiter aufgeklammert. Das Gehäuse umschließt den Stromleiter dabei nicht.

Aus der US 7,164,263 B2 ist eine Messeinrichtung für die kontaktlose Strommessung eines stromdurchflossenen elektrischen Leiters bekannt, bei dem auf einer bogenförmigen Leiterplatte eine Vielzahl von magnetischen Feldsensoren angeordnet ist. Die Leiterplatte ist in bogenförmigen Gehäusehälften, sich radial erstreckend, angeordnet, die im geschlossenen Zustand den Leiter umgeben.

Aus der EP 2 541 261 A1 ist ebenfalls eine Strommesseinrichtung bekannt, bei der ein Gehäuseoberteil gegenüber einem Gehäuseunterteil verschwenkbar gelagert ist und eine Ausnehmung zur Aufnahme eines stromführenden Leiters aufweist. In die verschwenkbare Gehäusehälfte ist eine magnetische Folie einlegbar, die partiell den Leiter beim Zusammendrücken beider Gehäusehälften umschließt. Unterhalb des Leiters befindet sich der Stromsensor auf einer Leiterplatte, die von der magnetischen Folie abgedeckt ist.

Aus der DE 25 43 828 A1 ist eine Vorrichtung zum Messen von elektrischen Strom, Gleichstrom und Wechselstrom bekannt, der dem Gleichstrom überlagert ist. Diese Vorrichtung besteht aus einer Zange mit Induktivspulen, deren Backen eine Ausnehmung für den stromführenden Leiter im geschlossenen Zustand umschließen.

US 2010/0237853 A1 offenbart eine Messvorrichtung für elektrische Leiter. Die Messvorrichtung weist zwei Gehäuseteile auf, die miteinander verbindbar sind. Eines der Gehäuseteile weist eine halbzylindrische Aufnahme auf, in der ein magnetisches Abschirmelement und ein Verbindungsmittel angeordnet sind, wobei der elektrische Leiter über das Verbindungsmittel gegen einen Hallsensor gedrückt wird, der an dem gegenüberliegendem Gehäuseteil angeordnet ist. Alternativ wird der Hallsensor über eine Feder gegen den elektrischen Leiter gedrückt, der auf dem magnetischen Abschirmelement und der Aufnahme aufliegt.

DE 10 2007 035 184 A1 offenbart eine Vorrichtung zum Messen eines durch einen elektrischen Leiter fließenden Stromes, welcher einen ringförmigen Grundkörper mit einer Öffnung und wenigstens einen Sensor aufweist zur Erfassung eines durch den Stromfluss erzeugten Feldes, wobei der Grundkörper aus wenigstens zwei Segmenten besteht, welche lösbar miteinander verbunden sind.

US 2006/006976 A1 offenbart ebenfalls eine Vorrichtung zum Messen eines durch einen elektrischen Leiter fließenden Stromes, wobei zwei Ringhälften miteinander verbunden werden können, um einen Leiter zu umgeben.

Ausgehend vom gattungsbildenden Stand der Technik liegt der Erfindung die Aufgabe zugrunde, die Messeinrichtung derart zu gestalten, dass die Gehäuseteile ungehindert geöffnet werden können, um das Gehäuse auf einzelne Leiter eines verkabelten Systems auf einfache Weise aufschieben zu können, und neben einer kontaktlosen Strommessung auch eine flache gestreckte Bauweise des Gehäuses ermöglicht wird.

Die Aufgabe löst die Erfindung durch Ausgestaltung der Messeinrichtung gemäß der in Anspruch 1 angegebenen technischen Lehre. Um eine Energieanalyse zu ermöglichen, ist ferner eine Spannungsmessung in weiterer Ausgestaltung vorgesehen.

Vorteilhafte Weiterbildungen der Erfindung sind in den Unteransprüchen im Detail angegeben.

Gemäß der Erfindung nach Anspruch 1 ist vorgesehen, dass das erste und das zweite Gehäuseteil an den Fügeseiten im Inneren mindestens je eine im Wesentlichen halbzylinderförmige Lagerschale aufweisen, die bei geschlossenem Gehäuse den Leiter im Wesentlichen konzentrisch umschlie-βen, dass die Lagerschalen gegenüber dem Leiter einen so großen Durchmesser aufweisen, dass in diese mindestens ein flexibler formangepasster Leiterbahnträger mit mindestens einem Magnetfeldsensor einlegbar ist, der zwei bogenförmige Abschnitte aufweist, die an der dem Schwenklager zugewandten Seite über einen derart im Gehäuse gelagerten schlaufenförmigen Verbindungsabschnitt miteinander verbunden sind, dass mindestens die relative Schwenkbewegung der Gehäuseteile beim Öffnen und Schließen des Gehäuses gewährleistet ist bzw. nicht behindert wird, und dass der im ersten Gehäuseteil verlegte Abschnitt des mit Leiterbahnen versehenen flexiblen Leiterbahnträgers mit einer starren oder flexiblen Leiterplatte mechanisch und elektrisch verbunden ist.

Als Magnetfeldsensor kann gemäß der Erfindung beispielsweise ein Hallsensor oder ein magnetoresistiver Sensor verwendet werden. Es hat sich ferner gezeigt, dass mindestens zwei Hallsensoren zu einem befriedigenden Messergebnis führen. Die Magnetfeldsensoren sind auf dem flexiblen Leiterbahnträger derart angeordnet, dass die Magnetfeldkomponenten durch tangentiale Messung ermittelbar sind. Sie können zu diesem Zweck auf der Chip-Oberfläche z. B. eines ASICs parallel verlaufend aufgebracht sein und nicht, wie bei Hallsensoren üblich, vertikal. Solche Hallsensoren sind z. B. aus der 20 2007 005 957 U1 bekannt. Einsetzbare magnetoresistive Sensoren zur Magnetfeldmessung sind beispielsweise in der Zeitschrift Automotive, Ausgabe vom 07.08.2004, S. 24ff, beschrieben

Die Ausbildung hat den Vorteil, dass der oder die Magnetfeldsensoren, die vorzugsweise auf der Innenseite des flexiblen Leiterbahnträgers in den bogenförmigen Abschnitten angebracht sind, die den Leiter umschließen, direkt mit den Leiterbahnen kontaktiert werden können. Der elektrische Strom in einem Leiter wird durch Näherung des Ringintegrals der magnetischen Flussdichte um den Leiter herum ermittelt. Dazu sind in vorteilhafter Weise als Magnetfeldsensoren mehrere identische, hoch integrierte Hallsensor-ASICs auf einem flexiblen Leiterbahnträger aufgebracht. Der Leiterbahnträger braucht dabei nicht aufgetrennt zu werden. Um den Leiter herum wird der flexible Leiterbahnträger zu einer geschlossenen Kurve geformt. Dies kann direkt durch die schalenförmigen Aufnahmen erfolgen oder aber auch durch eine Vorverformung mittels den Einsätzen in die Lagerschalen. Durch den mechanischen Aufbau, die Anordnung der Magnetfeldsensoren auf dem flexiblen Substrat und die Fähigkeit der Sensoren, Magnetfelder parallel zur Chipoberfläche messen zu können, ist der Fehler für die Näherung des Ringintegrals vernachlässigbar. Mit den Magnetfeldsensoren lässt sich die magnetische Flussdichte an äquidistanten Punkten entlang einer kreisförmigen Kurve um den stromführenden Leiter in tangentialer Richtung zur gedachten Integralgradationskurve messen und dient als Maß für den Strom. Die Hallsensoren sind in einer Ausführungsform als Magnetfeldsensoren in ASICs eingebunden und bieten den Vorteil, dass auch DC-Ströme und nicht nur Wechselströme gemessen werden können. Die Mess- und Auswerteverfahren sind als solche bekannt.

Die erfindungsgemäße Anordnung stellt sicher, dass die Bestückung des flexiblen Leiterbahnträgers in der Ebene ermöglicht wird und dass danach durch entsprechende Formgebung oder durch Einschieben in die Lagerschale in gewünschter Weise durch die beiden bogenförmigen Abschnitte der Leiter vollständig umschlossen wird. Das schlaufenförmige Verbindungsstück zwischen den beiden Abschnitten stellt dabei sicher, dass das Gehäuse stets geöffnet werden kann, also der obere Gehäuseteil gegenüber dem unteren aufgeschwenkt werden kann, um das untere Gehäuseteil und das obere Gehäuseteil von einem Leiter gemeinsam abziehen zu können. Die gegebenen Fertigungsvorteile bei der Bestückung, aber auch bei der Einbringung in die Gehäuseteile eines Gehäuses, sind offensichtlich.

Die beiden Gehäuseteile sind über ein oder mehrere Schwenkgelenke oder auch über ein aus Schwenkgelenken bestehendes Scharnier miteinander einseitig verbunden, während an der anderen Seite ein Rastverschluss vorgesehen sein kann oder aber auch eine andere Schlosssicherung, die Teile miteinander verbinden kann. Es versteht sich ebenfalls von selbst, dass die Durchbrüche in den Seitenwänden, die aus Halbschalen bestehen, so groß sein müssen, dass der Leiter, der im Durchmesser beispielsweise zwischen 1 mm und 24 mm groß sein kann, eingelegt werden kann. Grundsätzlich können unisolierte Leiter eingelegt werden. Es können aber auch mit einer Isolierschicht versehene, also ummantelte, Leiter eingesetzt werden.

Damit die VDE 100-Bedingungen eingehalten werden und ein ausreichender Berührungsabstand zwischen dem flexiblen Leiterbahnträger und den sich darauf befindlichen Leiterbahnen sowie den Bauelementen zum stromführenden Leiter gegeben ist, ist in weiterer Ausgestaltung vorgesehen, dass zwischen dem Leiter und dem flexiblen Leiterbahnträger mindestens im Bereich der Lagerschalen Flächenelemente aus Isoliermaterial mit den Leiter umschließenden Ausformungen in den Gehäuseteilen eingefügt sind. Es versteht sich von selbst, dass der schlaufenförmige Verbindungsabschnitt dann oberhalb und unterhalb der aufeinanderliegenden Flächenelemente rückwärtig in der Ausnehmung der beiden Gehäuseteile verlegt ist, um eine Öffnung der beiden Gehäuseteile durch Verschwenken um an den Seitenwänden sich befindliche Schwenkgelenke zu ermöglichen.

Um ein noch leichteres Einlegen des Leiters zu ermöglichen, kann das Schwenkgelenk auch durch eine einfache Aufstellsicherung realisiert werden, es muss also kein fester Verbund zwischen den beiden Gehäuseteilen durch ein statisches Schwenkgelenk hergestellt sein. Die Gehäuseteile können so miteinander verbunden sein, dass das zweite Gehäuseteil gegenüber dem ersten Gehäuseteil nach dem Überschwenken in der Höhe um einen definierten Weg beim Verschließen verschiebbar ist, wozu an den ersten und den zweiten Gehäuseteilen ineinandergreifende Führungselemente und Führungen vorgesehen sind. In einer vorteilhaften Ausführung können also an dem unteren Gehäuseteil oder an einem Einsatz in dem unteren Gehäuseteil, der die Bauelemente alle aufnimmt, die darin eingesetzt sind, nach oben vorstehende säulenförmige Führungselemente vorgesehen sein, z. B. in den Eckenbereichen, die in Führungskanäle in dem zweiten Gehäuseteil gleitend eingreifen. Zur Verbundsicherung können an den Führungselementen Rastnasen vorgesehen sein, die eine Rastkante in der Führung im zweiten Gehäuseteil rastend übergreifen. Die Führungen sind U-förmige Kanäle, die in der Form dem Querschnitt der säulenförmigen Führungselemente angepasst sind. Der Führungskanal kann an der Fügeseite des Gehäuseteils einen abgeschrägten Einlauf aufweisen, der mit einer Sperrvorderseite beim Kippen des Gehäuseteils, in dem sich der Kanal befindet, gegen das Führungselement greift und gleichzeitig eine geöffnete Schrägstellung des Gehäuseteils ermöglicht. Das Schwenkgelenk ist also hierüber realisiert und kann bedient werden, wenn das obere Gehäuseteil vom unteren in die obere Höhenposition verbracht ist.

Grundsätzlich können die Lagerschalen, Halter, Stützelemente und dergleichen in dem Gehäuse des unteren Gehäuseteils eingebracht oder einteilig aus Kunststoff ausgeformt sein. Es ist aber auch möglich, diese Teile und Lagerungen an einem Einsatz vorzusehen, der gesondert gefertigt wird und auch mit den Führungselementen versehen ist, falls diese vorhanden sind, welcher Einsatz in das Gehäuseteil dann nach der Bestückung eingesetzt wird. Ein solcher Einsatz kann selbstverständlich auch in dem oberen Gehäuseteil vorgesehen sein und mit dem unteren Gehäuseteil verbunden sein.

Der Leiter kann aus mehreren Drähten bestehen und verseilt ausgebildet sein, er kann flexibel sein oder aber auch als stromführender Einzeldraht vorgesehen sein. Die Auswerteeinrichtung ist auf einer festen Leiterbahn oder einem flexiblen Leiterbahnträger, der mit dem flexiblen Träger für die Magnetfeldsensoren eine Einheit bilden kann und beispielsweise auf eine Isolierplatte aufgezogen sein kann, aufgebracht. Hierbei handelt es sich um elektrische Verstärker, einem die Auswertung bewirkenden ASIC und/oder einem programmierten Mikroprozessor. Die Daten können über eine feste Schnittstelle, beispielsweise eine Steckverbinderschnittstelle, abgegriffen werden. Die entsprechenden Buchsen oder Steckerkontakte sind mit der Leiterplatte verbunden und über eine Ausnehmung im Gehäuse zugänglich bzw. stehen die Steckverbinder in dieser Ausnehmung hervor, um das Steckverbinder-Komplementärstück aufstecken zu können. Die Messdaten können aber auch in einem Speicher abgelegt sein, der Bestandteil eines RFID-Transponders ist, so dass die Messdaten durch einen RFID-Empfänger ausgelesen und ausgewertet werden können. Im Übrigen lassen sich die Messdaten auch durch Fernwirktechnik auslesen, wenn eine entsprechende Einkopplung in den Leiter erfolgt.

Als besonders vorteilhaft hat es sich erwiesen, die Lagerschalen rückseitig in kammerförmige Ausnehmungen oder in einen Hohlraum in den Gehäuseteilen münden zu lassen, in denen der schlaufenförmige Verbindungsabschnitt an dem flexiblen Leiterbahnträger eingreifen kann, wobei der äußere Bogenabschnitt des Verbindungsabschnitts nahe, bei oder auf der Schwenkachse der beiden Gehäuseteile liegt. Es ist ersichtlich, dass hierdurch ein Aufklappen und Zuklappen der beiden Gehäuseteile um die Scharniere ermöglicht wird, ohne dass eine mechanische Überlastung des schlaufenförmigen Verbindungsabschnittes erfolgt. Dies erhöht die Einsatzdauer solcher Messeinrichtungen wesentlich, auch dann, wenn diese vielfach zur Leitungsmessung unterschiedlicher Leiter herangezogen werden.

In weiterer Ausgestaltung ist vorgesehen, dass an der starren oder flexiblen Leiterplatte ein weiterer flexibler Abschnitt oder eine Verlängerung angebracht ist, an dem oder an der ein Messstift befestigt und mit einer Leiterbahn kontaktiert ist. Der Messstift wird mit seiner Spitze auf den Leiter zur Spannungsmessung gedrückt und, falls eine Isolierung den Leiter umgibt, wird diese beim Schließen des Gehäuses bis zum Leiter durchgedrückt. Dies ermöglicht eine Energieanalyse, da parallel zur Strommessung zugleich auch die Spannung gemessen wird und damit die Leistung erfassbar ist und daraus eine Energieanalyse erstellt werden kann. Der enthaltene Mikroprozessor muss entsprechend programmiert sein, um die Messwerte zeitgebunden bei der Energieanalyse auswerten zu können.

Es ist ersichtlich, dass die Kontaktierung des Messstiftes ebenfalls mit der Leiterbahn auf einem flexiblen Leiterbahnträger möglich ist, der z. B. über eine Anschlusszunge parallel zu dem flexiblen Leiterbahnenträger für die Magnetfeldsensoren im Gehäuse verlegt ist. Grundsätzlich können die Lagerschalen zur Aufnahme des flexiblen Leiterbahnträgers für die Magnetfeldsensoren einseitig gelagert vorgesehen sein. Der Messstift kann zwischen diesem und der Gehäusewand angeordnet sein. Es ist aber auch eine beabstandete Anordnung möglich, wobei die Leiterplatte, auf der sich die Auswerteeinrichtung befindet, zwischen den beiden Messpunkten angeordnet ist. Dies liegt im Belieben des Fachmannes.

Die Lagerschalen für die bogenförmigen Abschnitte des flexiblen Leiterbahnträgers für die Magnetfeldsensoren können im Gehäuse fest eingeformt sein. Sie können aber auch durch Formteile - zumindest an einer Seite - realisiert sein, die in das Gehäuse einsetzbar sind. Wenn diese Formteile einsetzbar sind, ist auf einfache Weise durch entsprechende Bestückung eine Anpassung des Durchmessers des Durchgangs an den Durchmesser des Leiters oder des Kabels durchführbar, damit ein geringer Abstand zwischen dem Leiter und dem Magnetfeldsensor gegeben ist. Die Lagerschalen können darüber hinaus geschlossen wannenförmig ausgebildet sein oder aber auch nur durch seitliche Konturen ausgeformt sein, so dass der mittlere Bereich des bogenförmigen Abschnitts, an dem die Magnetfeldsensoren angebracht sind, freiliegt, während die Seitenteile auf den Halbschalenflächen aufliegen oder an diesen, wie zuvor schon angegeben, durch Haltemittel gehalten sind. Die bogenförmigen Abschnitte können auch an den Halbschalen angeklebt sein. In jedem Fall sorgt das aus Kunststoff oder Keramik bestehende Gehäuse mit seinen schalenförmigen Aufnahmen dafür, dass alle Teile gegeneinander praktisch isoliert sind. Mit ein und demselben Gehäuse lassen sich beispielsweise Strommessungen an 240-V-Wechselspannungsleitungen oder Gleichstromleitungen durchführen und auch an Leitungen, die mehrere KV-Spannungen führen.

Um bei unterschiedlichen Durchmessern eine Anpassung des Messstiftes auf einfache Weise vornehmen zu können, ist in weiterer Ausgestaltung vorgesehen, dass der Messstift im ersten Gehäuseteil vor dem Durchbruch in der Stirnwand angeordnet ist und gegen die Kraft einer Feder derart abgestützt und/oder von einem Einstellelement untergriffen ist, dass der Leiter nach dem Einlegen in das Gehäuse von einem Niederhalter mindestens im Bereich des Messstiftes gegen diesen drückbar ist. Durch den Federdruck ist sichergestellt, dass die Messspitze des aus Metall bestehenden Messstiftes die Isolationsschicht durchdringt und eine Anpassung an unterschiedliche Durchmesser auf einfache Weise in einem definierten Bereich möglich ist.

Um eine Anpassung an unterschiedliche Durchmesser der stromführenden Leiter grundsätzlich vornehmen zu können, können die Aufnahmen an den Gehäuseteilen anklippbar oder ansteckbar vorgesehen sein, die beispielsweise in Ausnehmungen in den Gehäuseteilen ansteckbar sind und Lagerschalen zum Übergreifen der Leiter aufweisen. Durch eine solche modulare Anordnung ist es möglich, sowohl die Lagerschalen austauschbar zu gestalten als auch die Leitungsführung im Messbereich eines Messstiftes, aber auch in Bezug auf die Durchführung in den Seitenwänden des Gehäuses, zu verändern. Die einzelnen Baugruppen sind in das Gehäuse einsetzbar oder an das Gehäuse ansteckbar ausgebildet und bilden mit der Oberfläche des Gehäuses eine geschlossene Einheit.

Auch können beispielsweise die Aufnahmen für den Leiter so ausgebildet sein, dass der Messstift durch eine Wand hindurchtreten kann. Diese Aufnahme kann als Aufnahmeformteil beispielsweise auch zugleich das Schwenkgelenk oder einen Teil des Schwenkgelenkes bilden und wird von außen auf das Gehäuse in entsprechende Ausnehmungen eingerastet. Das Gegengelenk befindet sich dann an dem zweiten Gehäuseteil und ist mit dem ersten auf einfache Weise nach der kämmenden Zusammenführung durch Verbindungsstifte, die die Schwenkachse bilden, verbindbar. Diese Teile können auch verdrehbar ausgebildet sein, so dass eine Links/Rechts-Öffnung ermöglicht wird, vorausgesetzt, dass auch die Lagerschalen für die flexible Leiterplatte versetzbar bzw. um 180° verdrehbar angeordnet sind. Dies gilt gleichermaßen auch für die Leiterplatte in dem Gehäuse, damit eine seitenversetzte Anordnung ermöglicht wird. Auch kann das Gehäuse senkrecht sowohl links anschlagend als auch rechts anschlagend angeordnet sein.

Um eine leichtere Montage des flexiblen Leiterbahnträgers zu ermöglichen, sind in weiterer Ausgestaltung seitlich an den Lagerschalen Formteile vorgesehen, die in Lagerausnehmungen in den Gehäuseteilen einsetzbar sind und mindestens eine der Form der Lagerschale angepasste Ausnehmung, eine Nut oder einen Rand zur Aufnahme oder Anlage mindestens des die Lagerschale überstehenden Seitenstreifens des flexiblen Leiterbahnträgers aufweisen. Es ist ersichtlich, dass nach dem Einlegen des flexiblen Leiterbahnträgers durch Eindrücken dieser Formteile die Formgebung an die Lagerschale automatisch durch den aufgreifenden Rand erfolgt und darüber hinaus auch eine Lagesicherung durch entsprechend ineinander greifende Vorsprünge und Ausnehmungen gegeben ist. Bei Verwendung von eingeschnittenen Nuten ist eine seitliche Anfügung des flexiblen Leiterbahnträgers möglich.

Als vorteilhafte Weiterbildung der Aufnahme für den Leiter hat sich ein Freischneiden der Seitenwände der Lagerschale erwiesen, da dadurch die Seitenwände federnd nachgeben können, wenn beispielsweise ein Leiter eingelegt wird, der etwas dicker ist als der vorgegebene Durchmesser. Solche Abweichungen können insbesondere gegeben sein, wenn der Leiter von einer Isolierschicht umgeben ist. Die Anordnung in der Aufnahme, die in eine Ausnehmung des Gehäuseteils einsetzbar ist, hat den Vorteil, dass an diesem Schwenkgelenkelemente angebracht werden können, so dass eine doppelte Funktion erzielbar ist. Die Schwenkgelenkelemente bestehen in bekannter Weise aus Schwenklagerböcken, die beabstandet zueinander angeordnet sind und zwischen die ein einzelner Lagerbock einfügbar ist, der mit seitlichen Noppen in Lagerungsausnehmungen der seitlichen Lagerböcke greift. Es können aber auch Durchgangsbohrungen vorgesehen sein und ein Lagerbolzen oder Lagerzapfen eingeführt werden, um die Schwenkbewegung zwischen zwei solcher Teile zu ermöglichen. Wenn darüber hinaus die Teile symmetrisch ausgebildet sind, ist durch einfache 180°-Drehung und Anbringung an den beiden Gehäuseteilen ein Scharnier mit den gleichen Bauelementen realisierbar. Solche Aufnahmen bestehen aus Kunststoff und werden zweckmäßigerweise angeklippt. Zur Zentrierung des eingelegten Leiters können an der Innenseite der Lagerschale Erhebungen vorgesehen sein.

Die Form des Gehäuses sollte mindestens in Längsrichtung im Wesentlichen eckig ausgebildet sein, um beispielsweise auch hinter einer stromführenden Leitung, die parallel zu einer Montagewand verläuft, angebracht werden zu können. Bei Messungen im Milli-Ampere-Bereich kann der Einfluss von Fremdmagnetfeldern, einschließlich dem Erdmagnetfeld, dadurch eliminiert werden, dass die bogenförmigen Abschnitte von einer Metallschicht aus nichtmagnetischen Werkstoffen abgedeckt werden, wie dies aus der eingangs genannten Druckschrift DE 20 2008 012 593 U1 bekannt ist. Das Gehäuse kann selbstverständlich auch gestreckt ausgebildet sein und bogenförmige Endabschnitte aufweisen. Jede andere Form ist aber auch realisierbar. Für einsetzbare Aufnahmen empfiehlt es sich jedoch, eine gestreckte, eckige Ausführung zu wählen, damit dieselben Aufnahmen durch Drehung sowohl im oberen als auch im unteren Gehäuseteil verwendbar sind.

Die Erfindung wird nachfolgend anhand der in den Zeichnungen dargestellten Ausführungsbeispiele ergänzend erläutert.

In den Zeichnungen zeigen:
- FIG 1: in einer isometrischen Darstellung ein geschlossenes Gehäuse einer Messeinrichtung nach der Erfindung mit einem in Längsrichtung durchgeführten Leiter,
- FIG 2: in einer isometrischen Draufsicht das untere Gehäuseteil des Gehäuses gemäß Figur 1 in geöffnetem Zustand,
- FIG 3: das untere Gehäuseteil gemäß Figur 2 mit herausgenommenem Leiter und eingesetzten Scharnierformteilen mit Aufnahmen für den Leiter.
- FIG 4: eine isometrische Draufsicht auf das untere Gehäuseteil mit abgenommenen Scharnierformteilen,
- FIG 5: eine isometrische Darstellung einer Aufnahme mit einer Lagerschale für den Leiter und angeformten Schwenkgelenkelementen sowie Klipphalter,
- FIG 6: ein Formteil, das in das Gehäuse seitlich der Lagerschale einsetzbar ist und eine leichtere Montage des flexiblen Leitungsträgers ermöglicht und
- FIG 7: ein weiteres Ausführungsbeispiel einer Gehäuseausbildung in einer isometrischen Darstellung.

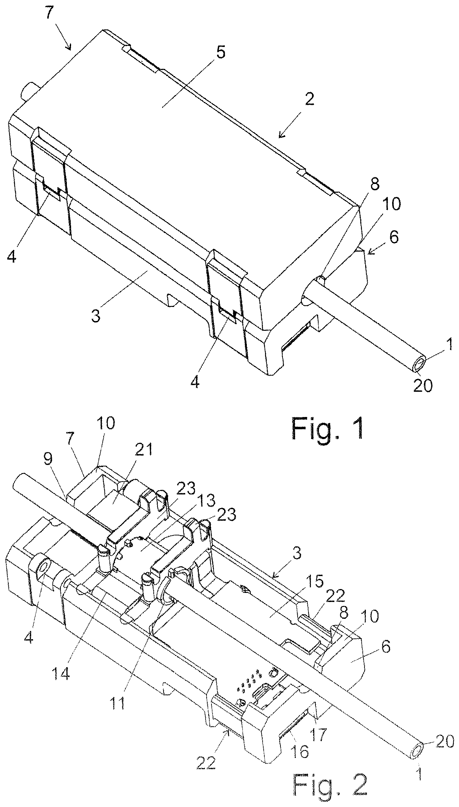

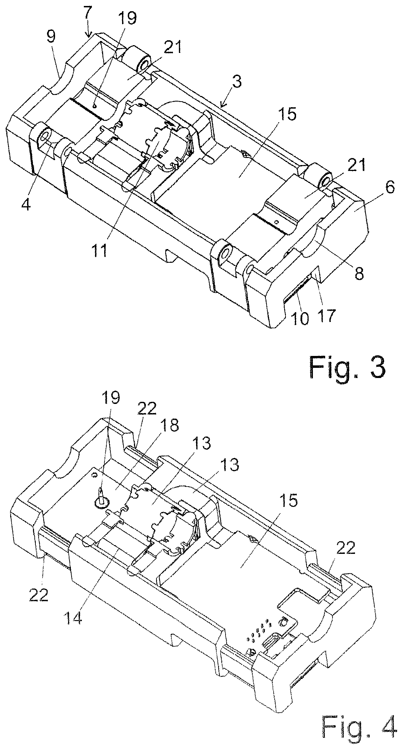

Das in den Figuren dargestellte Ausführungsbeispiel zeigt ein unteres Gehäuseteil 3 eines geschlossenen Gehäuses 2 und ein oberes Gehäuseteil 5. Beide Gehäuseteile 3 und 5 sind über zwei in Reihe angeordnete Schwenkgelenke 4 miteinander verbunden. Diese Schwenkgelenke 4 sind modulartig ausgebildet und von außen in Ausnehmungen 22 des Gehäuses 2 eingerastet. Wie aus Figur 3 ersichtlich, besteht jedes Schwenkgelenkmodul aus einer Aufnahme 21 mit einer innen liegenden Lagerschale 11, die in Längsrichtung verläuft und in die, wie aus Figur 2 zu ersehen ist, der Leiter 1, der mit einer Isolierschicht 20 umgeben ist, einlegbar ist. Die beiden Gehäuseteile 3 und 5 bilden im geschlossenen Zustand Stirnwände 6 und 7, die von Durchbrüchen 8 und 9 durchsetzt sind, die praktisch ein rundes Durchführloch für den Leiter 1 mit der Isolierung 2 bilden. Das Gehäuse 2 weist eine im Wesentlichen gestreckte rechteckförmige Grundform auf und ist mit Ausnehmungen 22 versehen, um die Aufnahmen 21, die mit den Gelenkteilen der Schwenkgelenke 4 versehen sind, aufnehmen zu können. Diese werden von außen aufgeklippt, und zwar sowohl im ersten Gehäuseteil 3 als auch im zweiten Gehäuseteil 5, so dass die Scharnierteile linksseitig ineinander greifen und durch einen nicht dargestellten Bolzen gesichert werden können, wie aus Figur 3 ersichtlich. Die entsprechenden Aufnahmen 21 sind um 180° gedreht an den beiden Gehäuseteilen 3 und 5 befestigt, um das kämmende Ineinandergreifen der Scharnierteile der Schwenkgelenke 4 zu ermöglichen. Im geschlossenen Zustand des Gehäuses 2 kann das gebildete Scharnier an anderen Seiten durch einen herausziehbaren Stift als Schloss genutzt werden. In dem Gehäuse 2 ist ferner eine Aufnahme vorgesehen, auf der eine Leiterplatte 15 befestigt ist. An dieser Leiterplatte 15 befinden sich die Kontaktbahnen für die elektronische Schaltung, aber auch ein Steckverbinder 16, z. B. eine USB-Schnittstelle, die aus einer Ausnehmung 17 in der Gehäusestirnwand 6 hervorsteht und von außen zugänglich ist. Hierüber können die Messwerte abgerufen werden, die von der Auswerteeinrichtung, die nicht darstellt ist, abgefragt werden kann.

Erfindungswesentlich ist der flexible Leiterbahnträger 13, der über ein zungenförmiges Übergangsteil mit der Leiterplatte 15 verbunden ist und in querverlaufender Richtung aufklappbar ist. Dieser Leiterbahnträger 13 nimmt die Magnetfeldsensoren, z. B. Hallsensoren, auf, die nicht dargestellt sind und beispielsweise Bestandteile von ASICs sein können. Der Leiterbahnträger 13 ist so geformt, dass er einen unteren bogenförmigen Abschnitt aufweist, der in eine Lagerschale 11 oder in seitliche lagerschalenförmige Aufnahmen einlegbar ist und den Leiter 1 beabstandet halbkreisförmig untergreift, während das obere Ende in die Lagerschale in dem oberen Gehäuseteil 5 eingebettet ist und den zweiten kreisbogenförmigen Teil bildet. Durch die Lagerung des Leiterbahnträgers in den Lagerschalen 11 ist ein völliges Umschließen des Leiters 1 mit der Isolierung in geschlossenem Zustand des Gehäuses 2 sichergestellt.

Damit ein einfaches Aufklappen der Gehäuseteile 3, 5 möglich ist, sind die beiden bogenförmigen Abschnitte des Leiterbahnträgers 13 über einen Verbindungsabschnitt 14, der schlaufenförmig ausgebildet ist, miteinander verbunden bzw. sind sie einteilig hiermit ausgebildet. Dieser Verbindungsabschnitt 14 liegt in einem Kammerbereich oder Hohlbereich des Gehäuses 2. Das hintere Bogenstück befindet sich nahe der durch die Schwenkgelenke 4 gebildeten Schwenkachse des Gehäuses 2. Es ist ersichtlich, dass beim Öffnen des Gehäuses 2 durch Verschwenken des oberen Gehäuseteils 5 gegenüber dem unteren Gehäuseteil 3 um das Drehgelenk 4 die in dem oberen Gehäuseteil 5 vorgesehenen, die Lagerschalen aufweisenden Formteile 23, die einsetzbar sind, mit aufgeschwenkt werden, wodurch der obere bogenförmige Abschnitt des Leiterbahnträgers 13 aufschwenkt, so dass der Leiter 1 eingelegt oder entnommen bzw. das Gehäuse 2 von dem Leiter 1 abgezogen werden kann.

Die Formteile 23 sind als Austauschteile konzipiert, so dass auch unterschiedliche Radien der Lagerschalen 11 realisiert werden können. Dies ist erforderlich, wenn beispielsweise ein Leiter 1 mit einem größeren Durchmesser eingelegt werden soll. Die Teile können in entsprechenden Aufnahmen sowohl in dem des unteren als auch des oberen Gehäuseteils 3 oder 5 eingesetzt werden.

Aus den Figuren 3 und 4 ist ersichtlich, dass neben der Strommessung mittels Magnetfeldsensoren auch die elektrische Spannung gemessen werden kann, die an dem Leiter 1 anliegt. Zu diesem Zweck ist ein Messstift 19 an einer Verlängerung 18 der Leiterplatte 15 oder an einer flexiblen Leiterplatte vorgesehen, die über ein nicht dargestelltes Verbindungsteil mit der Leiterplatte 15 verbunden ist. Der Messstift 19 kann gegen eine Feder verschiebbar angeordnet sein. Der Federdruck ist dabei mittels einer Schraube einstellbar, um die Durchdringung durch die Isolation 20 sicherzustellen, damit der Messstift 19 auf den Leiter 1 greifen kann, wenn der Leiter 1 von den Aufnahmen der Gehäuseteile 3 und 5 umschlossen ist. Es kann also sowohl eine kontaktlose Strommessung erfolgen als auch eine kontaktgebundene Spannungsmessung, so dass die Auswerteschaltung auch dafür verwendet werden kann, beispielsweise eine Energieanalyse vorzunehmen und die entsprechenden Daten bereitzustellen, was über einen Speicher auf der Leiterplatte 15 erfolgen kann. Der Speicher kann auch in einem RFID-Transponder eingebunden sein, um über ein RFID-Lesegerät den Transponder auslesen zu können, wenn keine direkten Kontaktmöglichkeiten, z. B. über eine USB-Schnittstelle 16, möglich ist.

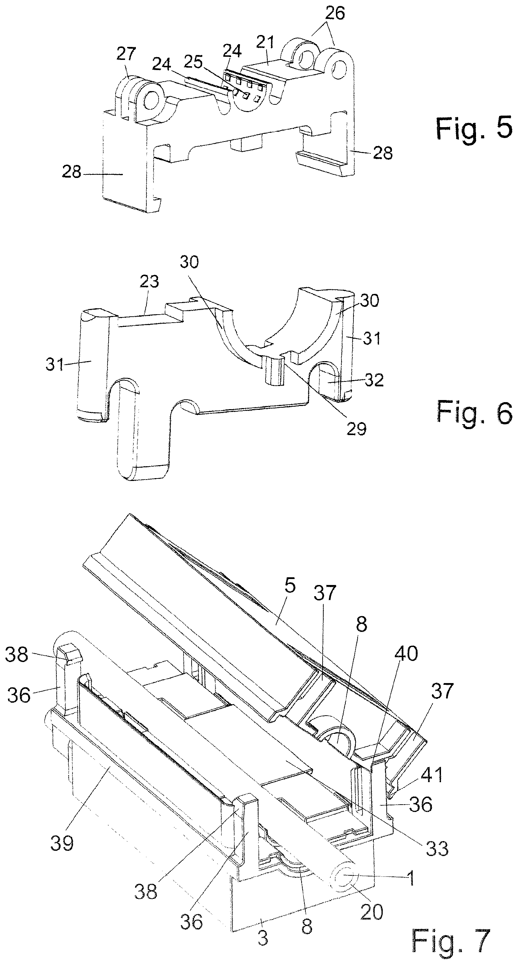

Fig. 5 zeigt eine Aufnahme 21, bei der die Lagerschale aus Seitenwänden 24 gebildet ist, die seitlich freigeschnitten sind. Die Wandstärke ist aber so gewählt, dass eine Federwirkung besteht, so dass eine Anpassung an unterschiedliche Außendurchmesser der Leiter 1, insbesondere deren Isolierung 20, möglich ist. Dadurch, dass die Seitenwand nachgibt, kann auch bei geschlossenem Gehäuse eine Höhenanpassung erfolgen. Um eine Zentrierung des Leiters zu gewährleisten, sind Erhebungen 25 an der Innenfläche vorgesehen. Die Darstellung zeigt ferner, dass die Schwenkgelenke 4 aus Schwenkgelenkelementen 26 und 27 gebildet werden können. Um die Aufnahme 21 mit dem Gehäuseteil 3 oder 5 jeweils verbinden zu können, sind Klipphalter 28 vorgesehen, die in entsprechend ausgeformte Ausnehmungen in den Gehäuseteilen einsetzbar sind, wie dies aus Fig. 2 ersichtlich ist.

In Fig. 6 ist das Formteil 23 hervorgehoben dargestellt. Dieses Formteil 23 kann seitlich an den Lagerschalen verlaufend in die Gehäuseteile 3, 5 eingebracht werden, zu welchem Zweck entsprechende Lagerausnehmungen in den Gehäuseteilen 3, 5 vorgesehen sind. Im Ausführungsbeispiel weist das Formteil 23 seitlich vorstehende Ränder 30 auf, deren untere Bogenflächen der Auflagebodenfläche der Lagerschale 11 in dem unteren Gehäuseteil 3 (nicht sichtbar) dem in dem oberen Gehäuseteil 5 entspricht. Es ist ersichtlich, dass beim Einlegen des flexiblen Leiterbahnträgers 13 durch Einsetzen des Formteiles 23 automatisch eine seitliche Arretierung und eine Formgebung des Leiterbahnträgers 13 auf die Schale 11 erfolgt. Die in dem Leiterbahnträger 13 vorgesehenen Ausnehmungen, die mit Aufnahmepunkten 29, z. B. Sicherungsnoppen, zusammenwirken können, verhindern ein Verschieben innerhalb der Lagerschalen 11. Dadurch ist eine axiale und radiale Lagersicherung der Magnetfeldsensoren, die sich auf dem Leiterbahnträger 13 befinden, gegeben. Die Darstellung zeigt ferner, dass das Formteil 23 Lagerabschnitte aufweisen kann, aber auch Durchführungen, beispielsweise für einen Teilabschnitt des Leiterbahnträgers 13.

In Fig. 7 ist ein weiteres Ausführungsbeispiel einer Gehäuseausbildung in einer perspektivischen Darstellung dargestellt, die sich von der in Fig. 1 im Wesentlichen dadurch unterscheidet, dass die beiden Gehäuseteile 3 und 5 neben der schwenkbaren Verbindung auch in der Höhenposition gegeneinander verstellbar sind. Zur Realisierung ist in dem unteren Gehäuseteil 3 ein Einsatz 39 eingesetzt, der in den Eckenbereichen säulenförmige Führungselemente 36 aufweist, die aus der Einsatzebene nach oben vorstehen. Die vier Führungselemente weisen obenseitig Rastnasen 38 auf, deren Funktion später noch erwähnt wird. In dem Einsatz sind stirnseitig Durchbrüche 8 vorgesehen, die der Form des eingelegten Leiters 1 mit der Isolierung 20 entsprechen. In der Zeichnung ist ferner ein Flächenelement 33 zu sehen, das aus Kunststoff besteht und eine Ausformung besitzt, die der Form des Leiters 1 mit der umgebenden Isolierung 20 entspricht. Dieses Flächenelement 33 ist gepaart mit einem solchen Führungselement (in Fig. 7 nicht dargestellt), das auflegbar ist, so dass die nicht dargestellten flexiblen Leiterplattenträger mit den aufgebrachten Sensoren und Schaltungselementen vollständig von dem Leiter 1 isoliert sind. Der obere Gehäuseteil 5 ist schräg gestellt in der Öffnungsstellung abgebildet. Es ist ersichtlich, dass die säulenartigen Führungselemente 36 mit den oberen Stirnflächen eine schräge Einlauffläche der kanalförmigen Führung 37 abstützen. Eine Sperrflanke 40, die an die Innenseiten der Führungselemente 36 greift, verhindert ein Abfallen. In der dargestellten Schrägstellung hintergreift eine Anschlagskante 41 an der Seitenwand des Gehäuseteils 5 das Führungselement 36. Diese Führungsverbindung bildet das Schwenkgelenk. Wird nun das Gehäuseteil 5 nach vorne gekippt, so gleiten die hinteren Führungselemente 36 in die Führungen 37 hinein. Die Rastnasen 38 drücken dabei gegen die inneren Gleitflächen der Führungen. Ebenso werden die vorderen Führungselemente 36 an dem Einsatz 39 in die vorderen Führungen 37 geführt, so dass das Gehäuseteil 5 in der Höhe gegenüber dem unteren Gehäuseteil 3 abgesenkt werden kann. In der Endstellung übergreifen die Rastnasen 38 die Kanten der Oberseite des oberen Gehäuseteils 5 und stellen die Verbindung sicher. Im Übrigen entspricht der weitere Aufbau dem Ausführungsbeispiel nach Fig. 1.

**Bezugszeichenliste**

| | | | |
|---|---|---|---|
| 1 | Leiter | 38 | Rastnase |
| 2 | Gehäuse | 39 | Einsatz |
| 3 | erstes Gehäuseteil | 40 | Sperrflanke |
| 4 | Schwenkgelenk | 41 | Anschlagskante |
| 5 | zweites Gehäuseteil | | |
| 6 | Stirnwand | | |
| 7 | Stirnwand | | |
| 8 | Durchbruch | | |
| 9 | Durchbruch | | |
| 10 | Stoßfläche | | |
| 11 | Lagerschale | | |
| 13 | Leiterbahnträger | | |
| 14 | Verbindungsabschnitt | | |
| 15 | Leiterplatte | | |
| 16 | Steckverbinder/USB-Schnittstelle | | |
| 17 | Ausnehmung | | |
| 18 | Verlängerung | | |
| 19 | Messstift | | |
| 20 | Isolierung | | |
| 21 | Aufnahme | | |
| 22 | Ausnehmung | | |
| 23 | Formteil | | |
| 24 | hinterschnittene Seitenwand | | |
| 25 | Erhebungen | | |
| 26 | Schwenkgelenkelement | | |
| 27 | Schwenkgelenkelement | | |
| 28 | Klipphalter | | |
| 29 | Aufnahmepunkt | | |
| 30 | Rand | | |
| 31 | Lagerabschnitt | | |
| 32 | Durchführung | | |
| 33 | Flächenelement | | |
| 36 | Führungselement | | |
| 37 | Führung | | |

## Patentansprüche

1. Messeinrichtung für mindestens eine kontaktlose Strommessung an einem stromdurchflossenen elektrischen Leiter (1), wobei mindestens ein magnetfeldempfindlicher Magnetfeldsensor als Strommesssensor mit einer entsprechenden elektronischen Auswerteeinrichtung in einem Gehäuse (2) angeordnet ist, das ein erstes Gehäuseteil (3) und ein damit über mindestens ein Schwenkgelenk (4) verbundenes zweites Gehäuseteil (5) aufweist, und in den Stirnwänden (6) Durchbrüche (8, 9) für die Durchführung des einlegbaren Leiters (1) vorgesehen sind, die derart geformt sind, dass nach relativen Aufschwenken des einen Gehäuseteils (3, 5) gegenüber dem anderen der Leiter (1) in die jeweiligen stirnseitigen Durchbruchteile des ersten Gehäuseteils (3) einlegbar ist, **dadurch gekennzeichnet, dass** das erste und das zweite Gehäuseteil (3, 5) an den Fügeseiten im Inneren mindestens je eine im Wesentlichen halbzylinderförmige Lagerschale (11) aufweisen, die bei geschlossenem Gehäuse (2) den Leiter (1) im Wesentlichen konzentrisch umschließen, dass die Lagerschalen (11) einen gegenüber dem Leiter (1) so großen Durchmesser aufweisen, dass in diese mindestens ein flexibler formangepasster Leiterbahnträger (13) mit dem mindestens einen Magnetfeldsensor einlegbar ist, der zwei bogenförmige Abschnitte aufweist, die an der dem Schwenklager (4) zugewandten Seite über einen derart im Gehäuse gelagerten schlaufenförmigen Verbindungsabschnitt (14) miteinander verbunden sind, dass mindestens die relative Schwenkbewegung der Gehäuseteile (3, 5) beim Öffnen und Schließen des Gehäuses (2) gewährleistet ist, und dass der im ersten Gehäuseteil (3) verlegte Abschnitt des mit Leiterbahnen versehenen flexiblen Leiterbahnträgers (13) mit einer starren oder flexiblen Leiterplatte (15) mechanisch und elektrisch verbunden ist.

2. Messeinrichtung nach Anspruch 1, **dadurch gekennzeichnet, dass** ein durch einen Durchbruch (8, 9) in einer Gehäusewand (6, 7) hindurch in dem ersten Gehäuseteil (3) zugänglich angeordneter oder ein in eine Ausnehmung (17) eingesetzter, mit der starren oder flexiblen Leiterplatte elektrisch und mechanisch verbundener Steckverbinder (16) vorgesehen ist, über welchen die Messdaten von der Auswerteeinrichtung abrufbar sind.

3. Messeinrichtung nach Anspruch 1, **dadurch gekennzeichnet, dass** die Lagerschalen (11) rückseitig in kammerförmigen Ausnehmungen oder einem Hohlraum in den Gehäuseteilen (3, 5) münden, in denen der schlaufenförmige Verbindungsabschnitt (14) an dem flexiblen Leiterbahnträger (13) eingreift, wobei der äußere Bogenabschnitt des Verbindungsabschnitts (14) nahe bei, auf der oder im Bereich der Schwenkachse der beiden Gehäuseteile (3, 5) liegt.

4. Messeinrichtung nach Anspruch 1, **dadurch gekennzeichnet, dass** an der starren oder flexiblen Leiterplatte (15) ein weiterer flexibler Abschnitt oder eine Verlängerung (18) angebracht ist, mit dessen mindestens einem Leiter ein Messstift (19) kontaktiert ist, der mit seiner Spitze auf den Leiter (1) zur Spannungsmessung drückt und falls eine Isolierung (20) den Leiter umgibt, diese beim Schließen des Gehäuses (2) bis zum Leiter (1) durchdringt, wobei der Leiter auf der gegenüberliegenden Seite in einer Aufnahme abgestützt ist, und dass der Messstift (19) im ersten Gehäuseteil (3) vor dem Durchbruch (9) in der Stirnwand (7) angeordnet ist und gegen die Kraft einer Feder derart abgestützt und/oder von einem Einstellelement untergriffen ist, dass der Leiter (1) nach dem Einlegen in das Gehäuse (2) von einem Niederhalter mindestens im Bereich des Messstiftes (19) gegen diesen drückbar ist.

5. Messeinrichtung nach Anspruch 1, **dadurch gekennzeichnet, dass** zwischen dem Leiter (1) und dem flexiblen Leiterbahnträger (13) mindestens im Bereich der Lagerschalen (11) zur Sicherstellung eines definierten Berührungsabstandes Flächenelemente (33) aus Isoliermaterial mit den Leiter (1) umschließenden Ausformungen in den Gehäuseteilen (3, 5) eingefügt sind.

6. Messeinrichtung nach Anspruch 1, **dadurch gekennzeichnet, dass** das zweite Gehäuseteil (5) gegenüber dem ersten Gehäuseteil (3) nach dem Überschwenken in der Höhe um einen definierten Weg beim Verschließen verschiebbar ist und an den ersten und den zweiten Gehäuseteilen (3, 5) ineinandergreifende Führungselemente (36) und Führungen (37) vorgesehen sind, und dass die Führungselemente (36) mit Rastnasen (38) über Sperrkanten an den Führungselementen (37) bei geschlossenem Gehäuse (2) greifen.

7. Messeinrichtung nach Anspruch 1, **dadurch gekennzeichnet, dass** in dem ersten oder dem zweiten Gehäuseteil (3, 5) ein Einsatz vorgesehen ist, in welchem Halter und Ausformungen enthalten sind, um die Bauelemente und den Leiter (1) zu tragen, welcher Einsatz (39) mit dem jeweils anderen Gehäuseteil (3 oder 5) verbindbar ist.

8. Messeinrichtung nach Anspruch 1, **dadurch gekennzeichnet, dass** zur Anpassung an die unterschiedlichen Durchmesser der stromführenden Leiter (1), mit oder ohne Isolierung (20), austauschbare Aufnahmen (21) an den Gehäuseteilen (3, 5) anklipp- oder ansteckbar vorgesehen sind, die in Ausnehmungen (22) in den Gehäuseteilen (3, 5) einsteckbar sind und Lagerschalen zum Umgreifen des Leiters (1) aufweisen, und dass bei geöffnetem Gehäuse (2) von den Innenseiten her die Aufnahmen (21) anklippbar sind, wobei diese aus Kunststoff gefertigte Lagerschalen aufweisen und mindestens hinter der Strommessanordnung und im Bereich des Messstiftes (19) vor oder hinter diesem angebracht sind.

9. Messeinrichtung nach Anspruch 1, **dadurch ge-kennzeichnet,** dass auf der Leiterplatte (15) neben der Auswerteeinrichtung mindestens ein RFID-Transponder mit einem Speicher angebracht ist, in dem die Messwerte abrufbar gespeichert sind.

10. Messeinrichtung nach Anspruch 1, **dadurch gekennzeichnet, dass** der bogenförmige Abschnitt des flexiblen Leiterbahnträgers (13) im Randbereich mindestens eine Ausnehmung oder ein Loch aufweist, mit der bzw. dem der flexible Leiterbahnträger (13) auf mindestens einem Aufnahmepunkt (29) ausrichtbar ist, und dass seitlich an den Lagerschalen (11) Formteile (23) vorgesehen sind, die in Lagerausnehmungen in den Gehäuseteilen (3, 5) einsetzbar sind und mindestens eine der Form der Lagerschale angepasste Ausnehmung, eine Nut oder einen Rand (30) zur Aufnahme oder Anlage mindestens des die Lagerschale (11) überstehenden Seitenstreifens des flexiblen Leiterbahnträgers (13) aufweisen.

11. Messeinrichtung nach Anspruch 10, **dadurch gekennzeichnet, dass** die Aufnahmepunkte (29) an den Lagerschalen (11) und/oder an den Formteilen (23) vorgesehen sind.

12. Messeinrichtung nach Anspruch 1U, **dadurch gekennzeichnet, dass** das Formteil (23) einen hintergreifbaren, seitlich vorstehenden Rand (30) aufweist, der den Randstreifen des flexiblen Leiterbahnträgers (13) übergreift, und dass im Bereich des Randes (30) an dem Formteil (23) und/oder im Rand (30) Ausnehmungen und Nocken für die Lagersicherung der Magnetfeldsensoren und/oder des flexiblen Leiterbahnträgers (13) vorgesehen sind und der flexible Leiterbahnträger (13) entsprechende Ausformungen aufweist.

13. Messeinrichtung nach Anspruch 8, **dadurch gekennzeichnet, dass**
- die Lagerschalen hinterschnittene Seitenwände (24) aufweisen und federnd ausgebildet sind, und Erhebungen (25) zum Zentrieren des eingelegten Leiters an der Innenseite der Lagerschale vorgesehen sind, und an den Aufnahmen (21) außenseitig im Eckenbereich vorstehend Schwenkgelenkelemente (26 und 27) vorgesehen sind, die durch gedrehte Anordnung mit an dem anderen Gehäuseteil (3, 5) vorstehenden Gegenelementen (26, 27) verbindbar sind, und/oder
- an den Aufnahmen (21) seitlich Klipphalter (28) vorgesehen sind.

14. Messeinrichtung nach Anspruch 1, **dadurch gekennzeichnet, dass** der mindestens eine Magnetfeldsensor an der Innenseite an einem bogenförmigen Abschnitt des flexiblen Leiterbahnträgers (13) angebracht ist oder dass mehrere Magnetfeldsensoren in gleichgerichteten oder in verschiedenen Winkelstellungen zur Längsachse des Leiters (1) an den Innenseiten der bogenförmigen Abschnitte vorgesehen sind.

15. Messeinrichtung nach Anspruch 1, **dadurch gekennzeichnet, dass** bogenförmigen Abschnitte des flexiblen Leiterbahnträgers (13) außenseitig von einer Abschirmung aus einem nichtmagnetisierbaren metallischen Werkstoff umgeben sind oder ein solcher Werkstoff auf die Oberfläche aufgebracht ist.

16. Messeinrichtung nach Anspruch 1, **dadurch gekennzeichnet, dass** der Magnetfeldsensor ein Hallsensor oder ein magnetoresistiver Sensor ist, und dass die Magnetfeldsensoren auf flexible Leiterbahnträger (13) derart angeordnet sind, dass die Magnetfeldkomponenten durch tangentiale Messung ermittelbar sind.

## Claims

1. Measuring device for at least one contactless current measurement on an electrical conductor (1) through which current flows, in which at least one magnetic field-sensitive magnetic field sensor being arranged as a current measurement sensor with a corresponding electronic evaluation device in a housing (2) which has a first housing part (3) and a second housing part (5) connected thereto by at least one pivot bearing (4), and openings (8, 9) are provided in the end walls (6) for the insertable conductor (1) to pass through, **characterized in that** the first and second housing parts (3, 5) each have, on the joint sides in the interior, at least one essentially half-cylindrical bearing shell (11) which, when the housing (2) is closed, enclose the conductor (1) essentially concentrically, **in that** the bearing shells (11) have a diameter which is so large in relation to the conductor (1) that at least one flexible form-fitting conductor carrier (13) with at least one magnetic field sensor can be inserted therein, which has two arcuate sections which are connected to one another on the side facing the pivot bearing (4) via a loop-shaped connecting section (14) which is mounted in the housing in such a manner **in that** at least the relative pivoting movement of the housing parts (3, 5) is ensured when the housing (2) is opened and closed, and **in that** the section of the flexible conductor carrier (13) provided with conductor tracks which is laid in the first housing part (3) is mechanically and electrically connected to a rigid or flexible printed circuit board (15).

2. Measuring device according to claim 1, **characterized in that** an opening (8, 9) which is arranged in an end wall (6, 7) in the first housing part (3) accessible through a recess (17) a plug connector is provided which is electrically and mechanically connected to the rigid or flexible printed circuit board, via which plug connector the measurement data can be retrieved by the evaluation device.

3. Measuring device according to claim 1, **characterized in that** the bearing shells (11) open at the rear side in chamber-shaped recesses or a cavity in the housing parts (3, 5), in which the loop-shaped connecting section (14) engages on the flexible conductor carrier (13), the outer arc section of the connecting section (14) lying close to, on or in the region of the pivot axis of the two housing parts (3).

4. A measuring device according to claim 1, **characterized in that** a further flexible section or extension (18) is attached to the rigid or flexible printed circuit board (15), with at least one conductor of which a measuring pin (19) is contacted, which presses with its tip on the conductor (1) when the housing (2) is closed for voltage measurement and, if an insulation (20) surrounds the conductor, it penetrates this insulation to the conductor (1), wherein the conductor is supported on the opposite side in the receptacle, and that the measuring pin (19) is arranged in the first housing part (3) in front of the opening (9) in the end wall (7) and is supported towards the force of a spring and/or held under by an adjusting-element **in that**, after insertion into the housing (2), the conductor (1) can be pressed against the measuring pin (19) by a hold-down device at least in the region of the latter.

5. Measuring device according to claim 1, **characterized in that** between the conductor (1) and the flexible conductor carrier (13), at least in the region of the bearing shells (11), to ensure a defined contact distance, surface elements (33) made of insulating material with formations surrounding the conductor (1) are inserted in the housing parts (3, 5).

6. Measuring device according to claim 1, **characterized in that** the second housing part (5) is displaceable relative to the first housing part (3) after turning over in hight in a defined path during closing, and on the first and second housing parts (3, 5) interengaging guide-elements (36) and guides (37) are provided, and the guide elements (36) engage with latching lugs (38) via locking edges on the guide-elements (37) when the housing (2) is closed.

7. Measuring device according to claim 1, **characterized in that** in the first or the second housing part (3, 5) an insert is provided in which holders and recesses are contained in order to bear the components and the conductor (1), which insert (39) is connectable to the respective other housing part (3 or 5).

8. Measuring device according to claim 1, **characterized in that**, for adaptation to the different diameters of the current-carrying conductors (1), with or without insulation (20), exchangeable receptacles (21) are provided on the housing parts (3, 5) so that they can be recesses (22) in the housing parts (3, 5) and have bearing shells or gripping around the conductor (1), and, when the housing (2) is open, the receptacles (21) can be clipped on from the inner sides, these having bearing shells made of plastic and being fitted at least behind the current-measuring-arrangement and in the region of the measuring pin (19) in front of or behind the latter.

9. Measuring device according to claim 1, **characterized in that** on the printed circuit board (15) next to the evaluation device at least one RFID-transponder with a memory in which the measured values are stored in a retrievable manner is mounted.

10. Measuring device according to claim 1, **characterized in that** the arcuate section of the flexible conductor carrier (13) has at least one recess or hole in the edge area, with which the flexible conductor carrier (13) can be aligned on at least one mounting point (29), and **in that** mold-parts (23) are provided laterally on the bearing shells (11), which can be inserted into bearing recesses in the housing parts (3, 5) and have at least one recess adapted to the shape of the bearing shell, have a groove or an edge (30) for receiving or abutting at least the side strip of the flexible conductor carrier (13) projecting the bearing shell (11)

11. Measuring device according to claim 10, **characterized in that** the mounting points (29) are provided on the bearing shells (11) and/or on the mold-parts (23).

12. Measuring device according to claim 10, **characterized in that** the mold-part (23) has a laterally projecting edge (30) which can be engaged from behind, which overlaps the edge strip of the flexible conductor carrier (13) and **in that** recesses are provided in the region of the edge (30) on the mold-part (23) and/or in the edge (30) for securing the bearings of the magnetic field sensors and/or of the flexible conductor carrier (13), and the flexible conductor carrier (13) has corresponding recesses.

13. Measuring device according to claim 8, **characterized in that**
- the bearing shells have undercut side walls (24) and are spring-shaped and elevations (25) are provided for centering the inserted conductor on the inside of the bearing shell, and on the outside of the receptacles (21) projecting in the corner region pivot bearing elements (26 and 27) are provided, which are connectable by rotated arrangement with counter elements (26, 27) projecting at the other housing part (3, 5), and/or
- clip holders (28) are provided at the sides of the receptacles (21).

14. Measuring device according to claim 1, **characterized in that** the at least one magnetic field sensor is attached on the inside to an arcuate section of the flexible conductor carrier (13) or, **in that** a plurality of magnetic field sensors are provided in the same direction or in different angular positions relative to the longitudinal axis of the conductor (1) on the inner sides of the arcuate sections.

15. Measuring device according to claim 1, **characterized in that** arcuate sections of the flexible conductor carrier (13) are surrounded on the outside by a shield of a non-magnetizable metallic material or such a material is applied to the surface.

16. Measuring device according to claim 1, **characterized in that** the magnetic field sensor is a Hall-sensor or a magnetoresistive sensor, and that the magnetic-field-sensors are arranged on flexible conductor carrier (13), in such a way that the magnetic field components can be determined by tangential measurement.

## Revendications

1. Dispositif de mesure pour au moins une mesure de courant sans contact sur un conducteur électrique (1) parcouru par un courant, dans lequel au moins un capteur de champ magnétique sensible aux champs magnétiques, en tant que capteur de mesure de courant avec un dispositif d'évaluation électronique correspondant, est disposé dans un boîtier (2), qui présente une première partie de boîtier (3) et une deuxième partie de boîtier (5) reliées entre elles par l'intermédiaire d'au moins une articulation pivotante (4), et des passages (8, 9) pour le passage du conducteur (1) insérable sont prévus dans les parois frontales (6), qui sont formés de telle sorte qu'après un pivotement relatif d'une des parties de boîtier (3, 5) par rapport à l'autre, le conducteur (1) peut être inséré dans les parties de passage frontales respectives de la première partie de boîtier (3), **caractérisé en ce que** la première et la deuxième partie de boîtier (3, 5) présentent sur les faces de jonction intérieur au moins une coquille de palier (11) respective sensiblement semi-cylindrique, qui, lorsque le boîtier (2) est fermé, entourent le conducteur (1) de manière sensiblement concentrique, que les coquilles de palier (11) présentent un diamètre si grand par rapport au conducteur (1) qu'un support de piste conductrice flexible (13) de forme adaptée à celle dudit au moins un capteur de champ magnétique peut y être inséré, qui présente deux sections arquées, qui sont reliées l'une à l'autre sur la face tournée vers le palier pivotant (4) par l'intermédiaire d'une section de liaison de forme incurvée (14) montée dans le boîtier de telle sorte qu'au moins le mouvement pivotant relatif des parties de boîtier (3, 5) est assuré lors de l'ouverture et de la fermeture du boîtier (2), et que la section du support de piste conductrice flexible (13) pourvu de pistes conductrices, disposée dans la première partie de boîtier (3), est reliée mécaniquement et électriquement à une carte de circuits imprimés (15) rigide ou flexible.

2. Dispositif de mesure selon la revendication 1, **caractérisé en ce qu'**un connecteur (16) relié électriquement et mécaniquement à la carte de circuits imprimés rigide ou flexible, est disposé de manière accessible à travers un passage (8, 9) dans une paroi de boîtier (6, 7) dans la première partie de boîtier (3) ou un inséré dans un évidement (17), par l'intermédiaire duquel les données de mesure peuvent être consultées par le dispositif d'évaluation.

3. Dispositif de mesure selon la revendication 1, **caractérisé en ce que** le dos des coquilles de palier (11) débouchent dans des évidements en forme de chambre ou une cavité dans les parties de boîtier (3, 5), dans lesquelles la section de liaison en forme de boucle (14) s'engage sur le support de piste conductrice flexible (13), dans lequel la section incurvée extérieure de la section de liaison (14) se situe à proximité, sur le ou dans la zone de l'axe de pivotement des deux parties de boîtier (3, 5).

4. Dispositif de mesure selon la revendication 1, **caractérisé en ce qu'**une autre section flexible ou un prolongement (18) est fixé(e) sur la carte de circuits imprimés (15) rigide ou flexible, dont au moins un conducteur est mis en contact avec une tige de mesure (19) qui presse avec sa pointe sur le conducteur (1) pour la mesure de tension, et qui, si une isolation (20) entoure le conducteur, pénètre jusqu'au conducteur (1) lors de la fermeture du boîtier (2), le conducteur étant en appui sur la face opposée d'un logement, et la tige de mesure (19), dans la première partie de boîtier (3), étant disposée devant le passage (9) dans la paroi frontale (7) et en appui contre la force d'un ressort et/ou amenée en prise par le dessous par un élément de réglage de telle sorte que le conducteur (1), après son insertion dans le boîtier (2), peut être pressé par un dispositif de maintien contre la tige de mesure (19), au moins dans la zone de celle-ci.

5. Dispositif de mesure selon la revendication 1, **caractérisé en ce que** des éléments plans (33) composés d'un matériau isolant avec des parties saillantes entourant le conducteur (1) sont insérés dans les parties de boîtier (3, 5) entre le conducteur (1) et le support de piste conductrice flexible (13) au moins dans la zone des coquilles de palier (11), pour garantir une distance de contact définie.

6. Dispositif de mesure selon la revendication 1, **caractérisé en ce que** la deuxième partie de boîtier (5) peut se déplacer par rapport à la première partie de boîtier (3) après le pivotement par le dessus en hauteur selon une course définie lors de la fermeture et des éléments de guidage (36) et des guids (37) emboîtables sont prévus sur les premières et les deuxièmes parties de boîtier (3, 5), et les éléments de guidage (36) s'engagent avec des pattes de verrouillage (38) sur des bords de verrouillage des guides (37) lorsque le boîtier (2) est fermé.

7. Dispositif de mesure selon la revendication 1, **caractérisé en ce qu'**un insert est prévu dans la première ou la deuxième partie de boîtier (3, 5), dans lequel sont contenus des supports et parties saillantes, afin de porter les composants et le conducteur (1), lequel insert (39) peut être relié à l'autre partie de boîtier (3 ou 5) respective.

8. Dispositif de mesure selon la revendication 1, **caractérisé en ce que**, pour l'adaptation aux différents diamètres des conducteurs (1) conduisant le courant, avec ou sans isolation (20), des logements (21) interchangeables sont prévus de manière à pouvoir être clipsés ou enfichés sur les parties de boîtier (3, 5), introduits dans des évidements (22) dans les parties de boîtier (3, 5) et présentant des coquilles de palier pour enserrer le conducteur (1), et dans lequel, lorsque le boîtier (2) est ouvert, les logements (21) peuvent être clipsés de l'intérieur, en présentant des coquilles de palier en matière plastique et sont disposés au moins derrière le dispositif de mesure de courant et dans la zone de la tige de mesure (19), devant ou derrière celle-ci.

9. Dispositif de mesure selon la revendication 1, **caractérisé en ce qu'**au moins un transpondeur RFID est fixé sur la carte de circuits imprimés (15) à côté du dispositif d'évaluation, le transpondeur possédant une mémoire dans laquelle les valeurs de mesure sont stockées de manière à pouvoir être consultées.

10. Dispositif de mesure selon la revendication 1, **caractérisé en ce que** la section incurvée du support de piste conductrice flexible (13) présente, dans la zone de bord, au moins un évidement ou un trou, avec lequel le support de piste conductrice flexible (13) peut être orienté sur au moins un point de réception (29), et **en ce que** des pièces moulées (23) sont prévues latéralement sur les coquilles de palier (11), qui peuvent être insérées dans des évidements de palier dans les parties de boîtier (3, 5) et présentent au moins un évidement adapté à la forme de la coquille de palier, une rainure ou un bord (30) pour la réception ou l'appui d'au moins la bande latérale du support de piste conductrice flexible (13) faisant saillie de la coquille de palier (11).

11. Dispositif de mesure selon la revendication 10, **caractérisé en ce que** les points de réception (29) sont prévus sur les coquilles de palier (11) et/ou sur les pièces moulées (23).

12. Dispositif de mesure selon la revendication 10, **caractérisé en ce que** la pièce moulée (23) présente un bord (30) saillant latéralement qui peut être en prise par l'arrière et qui chevauche la bande de bord du support de piste conductrice flexible (13) par le dessus, et **en ce que** des évidements et des cames, pour le blocage de palier des capteurs de champ magnétique et/ou du support de piste conductrice flexible (13), sont prévus dans la zone du bord (30) sur la pièce moulée (23) et/ou sur le bord (30) des évidements et des cames, le support de piste conductrice flexible (13) présentant des parties saillantes correspondantes.

13. Dispositif de mesure selon la revendication 8, **caractérisé en ce que**
- les coquilles de palier présentent des parois latérales (24) dégagées et sont réalisées de manière élastique, et des bossages (25) sont prévus pour le centrage du conducteur inséré sur la face intérieure de la coquille de palier, et à l'extérieur des logements (21) sont prévus des éléments d'articulation pivotante (26 et 27), faisant saillie dans la zone d'angle, , qui peuvent être reliés par un agencement en rotation à des éléments complémentaires (26, 27) faisant saillie sur l'autre partie de boîtier (3, 5), et/ou
- des supports à clips (28) sont prévus latéralement sur les logements (21).

14. Dispositif de mesure selon la revendication 1, **caractérisé en ce que** l'au moins un capteur de champ magnétique est fixé sur la face intérieure d'une section incurvée du support de piste conductrice flexible (13) ou que plusieurs capteurs de champ magnétique sont prévus dans des positions angulaires dirigées dans la même direction ou dans des directions différentes par rapport à l'axe longitudinal du conducteur (1) sur les faces intérieures des sections incurvées.

15. Dispositif de mesure selon la revendication 1, **caractérisé en ce que** les sections incurvées du support de piste conductrice flexible (13) sont entourées côté extérieur par un blindage composé d'un matériau métallique non magnétisable ou un tel matériau est appliqué sur la surface.

16. Dispositif de mesure selon la revendication 1, **caractérisé en ce que** le capteur de champ magnétique est un capteur à effet Hall ou un capteur magnétorésistif, et **en ce que** les capteurs de champ magnétique sont disposés sur des supports de piste conductrice flexibles (13), de telle sorte que les composants de champ magnétique peuvent être déterminés par une mesure tangentielle.
